# EUROPEAN PATENT APPLICATION

(11) **EP 4 607 080 A1**
(43) Date of publication of application: **27.08.2025**
(21) Application number: 22962840.9
(22) Date of filing: 20.10.2022
(51) Int. Cl.: F16M 11/22, F16M 11/14, G02F 1/1333, H10K 50/80

(54) **DISPLAY DEVICE**

(71) Applicant: LG Electronics Inc., Yeongdeungpo-gu Seoul 07336 (KR)
(72) Inventor: HWANG, Minkyu, Seoul 06772 (KR); LEE, Jonghwan, Seoul 06772 (KR)
(74) Representative: Schornack, Oliver
(86) International application number: PCT/KR2022/016058
(87) International publication number: WO 2024/085278

(57) **Abstract**

A display device is disclosed. The display device according to the present disclosure includes: a head having a display panel; a stand for supporting the head; and a connector which connects the head to the stand, and which includes a rotary assembly that rotatably connects the head to the stand, wherein the rotary assembly can include: a rotary connector including a rotary part which is coupled to the head so as to rotate together therewith, and a fixed part which is rotatably coupled to the rotary part so as to rotate relative to the head; and a cable which penetrates the fixed part and which is electrically connected to the display panel.

## Description

### TECHNICAL FIELD

The present disclosure relates to a display device.

### BACKGROUND ART

With the development of information society, there has been a growing demand for various types of display devices. In order to meet such demand, various display devices, such as a liquid crystal display (LCD) device, a plasma display panel (PDP), an electro luminescent display (ELD), a vacuum fluorescent display (VFD), an organic light emitting diode (OLED) display, and the like, have been developed and used.

Among them, an LCD panel includes a TFT substrate and a color substrate that are opposite each other with a liquid crystal layer interposed therebetween, and can display an image using light provided from a backlight unit. In addition, an OLED panel can display an image by depositing a self-luminescent organic layer on a substrate having a transparent electrode formed thereon.

Recently, numerous research has been conducted on a structure for freely adjusting the angle or position of a display.

### DETAILED DESCRIPTION OF INVENTION

### TECHNICAL PROBLEMS

It is an object of the present disclosure to solve the above and other problems.

It may be another object to provide a display device including a stand for supporting a head

It may be another object to provide a structure that allows the angle or height of a head to be freely adjusted.

It may be another object to provide a structure that allows for flexible positioning of a stand for supporting a head.

It may be another object to provide a structure that allows a head to rotate 360 degrees.

It may be another object to provide a structure that prevents cable twisting or tangling during the rotation of a head.

### TECHNICAL SOLUTION

In accordance with an aspect of the present disclosure for achieving the above and other objects, a display device including: a head including a display panel; a stand to support the head; and a connector to connect the head and the stand; the connector including a rotary assembly configured to rotatably connect the head to the stand, wherein the rotary assembly includes: a rotary connector including a rotator coupled to the head so as to rotate together with the head, and a stator rotatably coupled to the rotator so as to rotate relative to the head; and a cable passing through the stator and electrically connected to the display panel.

### EFFECT OF INVENTION

A display device according to the present disclosure has the following effects.

According to at least one of the embodiments of the present disclosure, it is possible to provide a display device including a stand for supporting a head.

According to at least one of the embodiments of the present disclosure, it is possible to provide a structure that allows the angle or height of a head to be freely adjusted.

According to at least one of the embodiments of the present disclosure, it is possible to provide a structure that allows for flexible positioning of a stand for supporting a head.

According to at least one of the embodiments of the present disclosure, it is possible to provide a structure that allows a head to rotate 360 degrees.

According to at least one of the embodiments of the present disclosure, it is possible to provide a structure that prevents cable twisting or tangling during the rotation of a head.

Further scope of applicability of the present disclosure will become apparent from the following detailed description. However, it should be understood that the detailed description and specific embodiments such as preferred embodiments of the present disclosure are given by way of example only, since various changes and modifications within the idea and scope of the present disclosure may be clearly understood by those skilled in the art.

### BRIEF DESCRIPTION OF THE DRAWING

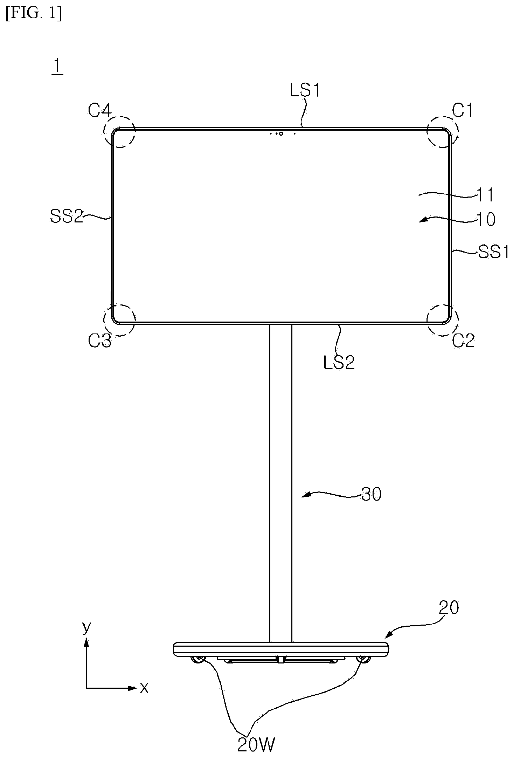

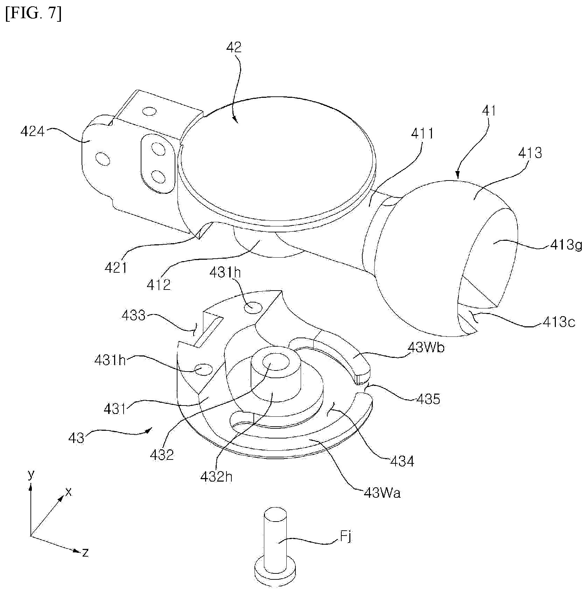

FIGS. 1 to 20 are diagrams illustrating examples of a display device according to embodiments of the present disclosure.

### MODE FOR CARRYING OUT THE INVENTION

Description will now be given in detail according to exemplary embodiments disclosed herein, with reference to the accompanying drawings. For the sake of brief description with reference to the drawings, the same or equivalent components may be denoted by the same reference numbers, and description thereof will not be repeated.

In the following description, a suffix such as "module" and "unit" may be used to refer to elements or components. Use of such a suffix herein is merely intended to facilitate description of the specification, and the suffix itself is not intended to give any special meaning or function.

In the present disclosure, that which is well known to one of ordinary skill in the relevant art has generally been omitted for the sake of brevity. The accompanying drawings are used to help easily understand various technical features and it should be understood that the embodiments disclosed herein are not limited by the accompanying drawings. As such, the present disclosure should be construed to extend to any alterations, equivalents, and substitutes in addition to those which are particularly set out in the accompanying drawings.

Although the terms "first", "second", etc. may be used herein to describe various elements, these elements should not be limited by these terms. These terms are only used to distinguish one element from another.

It will be understood that when a component is referred to as being "coupled" or "connected" to another component, it may be directly coupled or connected to another component, or intervening components may be present. In contrast, when a component is referred to as being "directly coupled" or "directly connected" to another component, there are no intervening components present.

A singular representation may include a plural representation unless the context clearly indicates otherwise.

Terms such as "comprises or includes" or "has" are used herein and should be understood that they are intended to indicate an existence of features, numbers, steps, operations, elements, components, or combinations thereof, disclosed in the specification, but do not preclude the presence or addition of one or more other features, numbers, steps, operations, elements, components, or combinations thereof.

The directions "up (U)", "down (D)", "left (Le)", "right (Ri)", "front (F)", and "rear (R)" shown in the drawings are used only for convenience of description, and the technical concept disclosed in this specification is not limited by these directions.

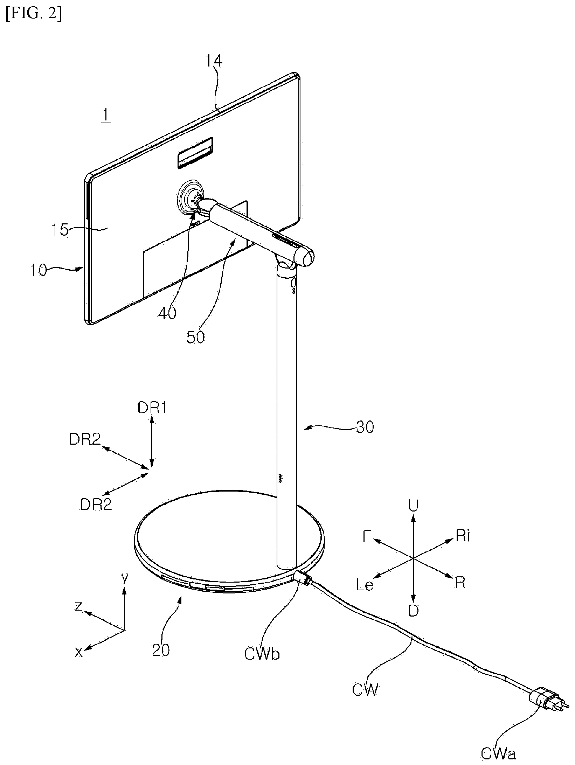

Referring to FIGS. 1 and 2, a display device 1 may include a head 10. The head 10 may display an image. The head 10 may be referred to as a display 10 or a display unit 10.

The head 10 may include a first long side LS1, a second long side LS2 opposite the first long side LS1, a first short side SS1 adjacent to the first long side LS1 and the second long side LS2, and a second short side SS2 opposite the first short side SS1. Meanwhile, for ease of explanation, it is illustrated and described that lengths of the first and second long sides LS1 and LS2 are greater than lengths of the first and second short sides SS1 and SS2, but the lengths of the first and second long sides LS1 and LS2 may be substantially equal to the lengths of the first and second short sides SS1 and SS2.

A direction parallel to the short sides SS1 and SS2 of the head 10 may be referred to as a first direction DR1 or an up- and-down direction. A direction parallel to the long sides LS1 and LS2 of the head 10 may be referred to as a second direction DR2 or a left-and-right direction. A direction perpendicular to the long sides LS1 and LS2 and the short sides SS1 and SS2 of the head 10 may be referred to as a third direction DR3 or a front-and-rear direction.

A direction in which the head 10 displays an image may be referred to as a front (F, z), and a direction opposite to the front may be referred to as a rear (R). The first short side SS1 may be referred to as a left side (Le, x). The second short side SS2 may be referred to as a right side (Ri). The first long side LS1 may be referred to as an upper side (U, y). The second long side LS2 may be referred to as a lower side (D).

The first long side LS1, the second long side LS2, the first short side SS1, and the second short side SS2 may be referred to as edges of the head 10. In addition, points where the first long side LS1, the second long side LS2, the first short side SS1, and the second short side SS2 meet one another may be referred to as corners.

A point where the first short side SS1 and the first long side LS1 meet may be referred to as a first corner C1. A point where the first short side SS1 and the second long side LS2 meet may be referred to as a second corner C2. A point where the second short side SS2 and the second long side LS2 meet may be referred to as a third corner C3. A point where the second short side SS2 and the first long side LS1 meet may be referred to as a fourth corner C4.

The display device 1 may include a base 20, a pole 30, a support arm 50, and a connector 40.

The base 20 may generally have the shape of a flat cylinder. The base 20 may be placed on a surface (e.g., a floor or the ground). A wheel 20W may be mounted to a lower surface of the base 20. The wheel 20W may include a plurality of wheels 20W. The wheels 20W allow a user to freely move the display device 1 placed on the surface.

The pole 30 may extend vertically. A lower end of the pole 30 may be coupled to the base 20. The pole 30 may be adjacent to a periphery of the base 20.

The support arm 50 may extend in a direction intersecting the pole 30. The support arm 50 may extend in a direction intersecting the pole 30 and the head 10. The support arm 50 may connect the head 10 and the pole 30. One side of the support arm 50 may be coupled to an upper end of the pole 30. The other side of the support arm 50 may be coupled to a rear side of the head 10. The other side of the support arm 50 may be coupled to the connector 40.

The connector 40 may be coupled to a rear surface of the head 10.

The base 20, the pole 30, the support arm 50, and the rotary-type connector 40 may be collectively referred to as a stand (20, 30, 50, 40). Accordingly, the head 10 may be supported by the connector 40, the support arm 50, the pole 30, and the base 20, and may be spaced upward from a surface.

Meanwhile, a power cable CW may be connected to an external power source. A plug CWa of the power cable CW may be connected to a concentric plug, and a jack CWb of the power cable CW may be connected to the base 20. A battery (not shown) may be installed in the base 20, the pole 30, and/or the head 10, and may be charged or discharged by power supplied via the power cable CW.

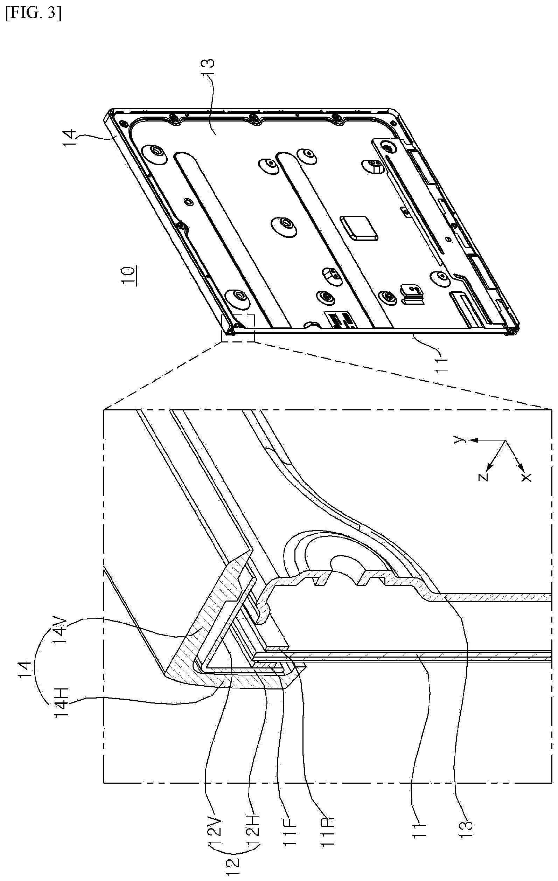

Referring to FIGS. 2 and 3, the head 10 may include a display panel 11, a middle cabinet 12, a frame 13, an end frame 14, and a back cover 15.

The display panel 11 may define a front surface of the head 10. For example, the display panel 11 may be an OLED panel, an LCD panel, or an LED panel. The display panel 11 may include a plurality of pixels to output an image in accordance with color, brightness, and chroma of each pixel. The display panel 11 may be divided into an active area in which an image is displayed and a de-active area in which no image is displayed. The display panel 11 may generate light corresponding to red, green or blue color in response to a control signal.

The middle cabinet 12 may extend along a periphery of the display panel 11. A horizontal part 12H may be positioned at the front of the display panel 11. A vertical part 12V may intersect the horizontal part 12H, and may cover a side surface of the display panel 11. For example, the middle cabinet 12 may include a metal or plastic material. The middle cabinet 12 may be referred to as a side frame or a guide panel.

The frame 13 may be positioned behind the display panel 11. Electronic components such as a printed circuit board (PCB) may be coupled to a rear surface of the frame 13. For example, the frame 13 may include a metal material. The frame 13 may be referred to as a mount plate or a module cover.

The end frame 14 may define a periphery of the head 10. A horizontal part 14H may be positioned at the front of the horizontal part 12H of the middle cabinet 12. A vertical part 14V may cover a side surface of the vertical part 12V of the middle cabinet 12. For example, the end frame 14 may include a metal or plastic material.

The back cover 15 may define the rear surface of the head 10. The back cover 15 may cover the rear of the frame 13, and may be coupled to the frame 13.

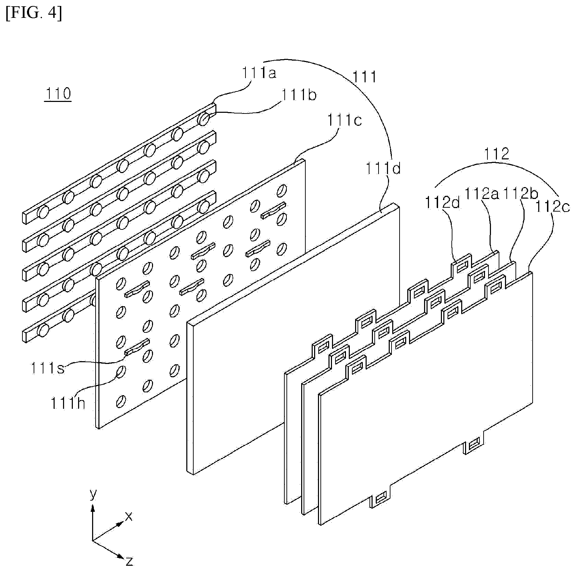

Referring to FIGS. 3 and 4, a backlight unit 110 may be disposed between the display panel 11 and the frame 13, and may be coupled to the frame 13. Here, the display panel 11 may be referred to as an LCD panel. The backlight unit 110 may include an optical layer 111 and an optical sheet 112. The optical layer 111 may include a substrate 111a, at least one light source 111b, a reflective sheet 111c, and a diffusion plate 111d.

The substrate 111a may be coupled to a front surface of the frame 13. The substrate 111a may have the shape of a plate, or may consist of a plurality of straps spaced apart from each other in the vertical direction. At least one light source 111b may be mounted on the substrate 111a. For example, the light source 111b may include a light emitting diode (LED). An electrode pattern for connecting an adapter to the light source 111b may be formed on the substrate 111a. The reflective sheet 111c may be positioned at the front of the substrate 111a. The reflective sheet 111c may have a hole 111h in which the light source 1 1 1b is positioned. The diffusion plate 111d may be positioned at the front of the reflective sheet 111c. A spacer 111s may support a rear surface of the diffusion plate 111d between the reflective sheet 111c and the diffusion plate 111d.

The optical sheet 112 may be positioned at the front of the diffusion plate 111d. A rear surface of the optical sheet 112 may be in close contact with the diffusion plate 111d, and a front surface of the optical sheet 112 may be in close contact with or adjacent to a rear surface of the display panel 11. The optical sheet 112 may include at least one of a diffusion sheet or a prism sheet. A coupling portion 112d may be formed on at least one edge of the optical sheet 112.

Accordingly, light from the light source 111b may be provided to the display panel 11 through the diffusion plate 111d and the optical sheet 112. Meanwhile, the display panel 11 of the present disclosure may be an OLED panel that does not require the backlight unit 110 described above, or may be another type of panel.

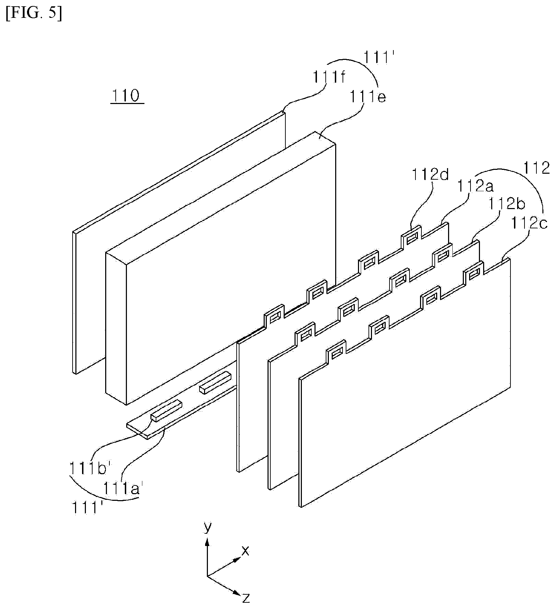

Referring to FIG. 3 and FIG. 5, a backlight unit 110' may be disposed between the display panel 11 and the frame 13, and may be coupled to the frame 13. Here, the display panel 11 may be referred to as an LCD panel 11. The backlight unit 110' may include an optical layer 111' and an optical sheet 112. The optical layer 111' may include a substrate 111a', at least one light source 111b', a reflective sheet 111f, and a light guide plate 111e. The light guide plate 111e may be disposed between the frame 13 and the optical sheet 112, and may be supported by the frame 13.

The substrate 111a' may be adjacent to a periphery of the light guide plate 111e, and may be coupled to the frame 13. At least one substrate 111b' may be mounted on the substrate 111a'. For example, the light source 111b' may include a light emitting diode (LED). An electrode pattern for connecting an adapter to the light source 111b' may be formed on the substrate 111a'. The reflective sheet 111f may be disposed between the frame 13 and the light guide plate 111e, and may be supported by the frame 13.

Accordingly, light from the light source 111b' may be provided to the display panel 11 through the light guide plate 111e and the optical sheet 112. Meanwhile, the display panel 11 of the present disclosure may be an OLED panel that does not require the backlight unit 110' described above or another type of panel.

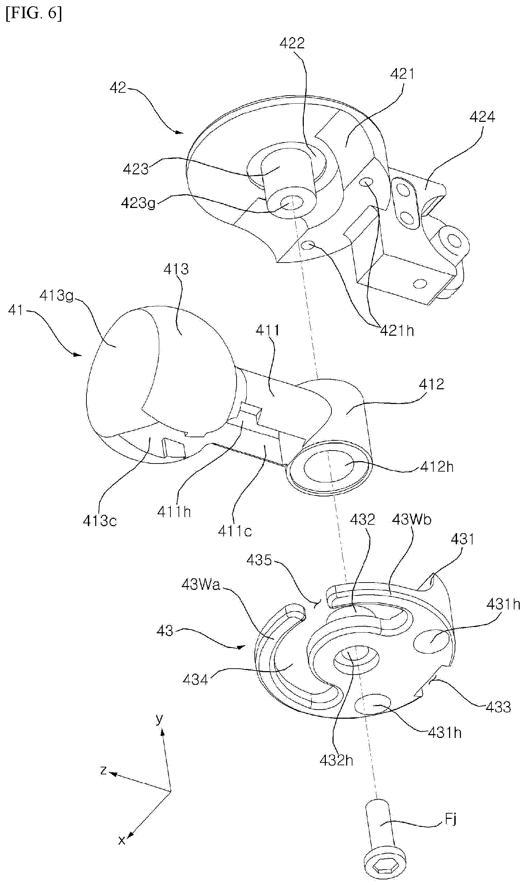

Referring to FIGS. 6, 7 and 8, the connector 40 may include a joint (42, 43). The joint (42, 43) may generally have the shape of a table tennis racket. The joint (42, 43) may be disposed between the head 10 and the support arm 50. The joint (42, 43) may be coupled to the support arm 50. The joint (42, 43) may include an upper part 42 and a rear part 424. The upper part 42 may have the shape of a circular plate. The rear part 424 may protrude rearward from the upper part 42. The rear part 424 and the support arm 50 may be coupled to each other.

An upper protruding portion 421 may protrude downward from the upper part 42. The upper protruding portion 421 may protrude downward from at least a portion of a lower surface of the upper part 421. The upper protruding portion 421 may extend along an arc of the upper part 421. The upper protruding portion 421 may extend in a circumferential direction of the upper part 42. A hole 421h may be formed through upper and lower surfaces of the upper protruding portion 421. The upper protruding portion 421 and a lower protruding portion 431 of a lower part 43, which will be described later, may be in contact with each other.

An upper groove 422 may be formed at a central portion of the upper part 42. The upper groove 422 may be formed by being recessed upward from the central portion of the lower surface of the upper part 42. The upper groove 422 may be formed in a circular or ring shape.

An upper pin 423 may protrude downward from a central portion of the upper groove 422. The upper pin 423 may be formed in a cylindrical shape. The upper pin 423 may be provided at its center with a pin groove 423g. The pin groove 423g may be formed by being recessed upward from a lower surface of the upper pin 423.

The joint (42, 43) may include a lower part 43. The lower part 43 may be positioned under the upper part 42. The lower part 43 may be coupled to the upper part 42. The lower part 43 may be opposite the upper part 42 with respect to a ball hinge 41. The lower part 43 may have the shape of a circular plate.

The lower protruding portion 431 may protrude upward from the lower part 43. The lower protruding portion 431 may protrude upward from at least a portion of an upper surface of the lower part 43. The lower protruding portion 431 may extend along an arc of the lower part 43. The lower protruding portion 431 may extend in a circumferential direction of the lower part 43. The lower protruding portion 431 may face the upper protruding portion 421. An upper surface of the lower protruding portion 431 and the lower surface of the upper protruding portion 421 may be in contact with each other. A hole 431h may be formed through the upper surface and a lower surface of the lower protruding portion 431. The hole 431h of the lower protruding portion 431 may be aligned with the hole of the upper protruding portion 421h. A fastening member such as a screw may be inserted into the hole 421h, 431h, and accordingly, the upper part 42 and the lower part 43 may be coupled to each other. In this case, the rear part 424 may be positioned in a cut-out 433 of the lower part 43.

A lower pin 432 may be formed at a central portion of the lower part 43. The lower pin 432 may protrude upward from the upper surface of the lower part 432. The lower pin 432 may be formed in a cylindrical shape. The lower pin 432 may face the upper pin 423. The lower pin 432 may be provided at its center with a pin hole 432h. The pin hole 432h may be formed through a lower surface of the lower part 43 and an upper surface of the lower pin 432. The pin hole 432h may be aligned with the pin groove 423g.

A slot 434 may be formed through the upper and lower surfaces of the lower part 43, and may extend along an arc of the lower part 43. The slot 434 may be opposite the lower protruding portion 431 with respect to the lower pin 432. A slot wall 43Wa, Wb of the lower part 43 may be positioned at the front of the slot 434. The slot wall 43Wa, Wb may be opposite the lower pin 432 with respect to the slot 434. The slot wall 43Wa, Wb may include a first slot wall 43Wa and a second slot wall 43Wb. An opening 435 may be formed between the first slot wall 43Wa and the second slot wall 43Wb, and may be connected to the slot 434.

The ball hinge 41 may be disposed between the upper part 42 and the lower part 43. The ball hinge 41 may include a body 411, a ring 412, and a ball 413.

The body 411 may be formed in a hollow cylindrical or cylindrical shape extending in the front-and-rear direction. The body 411 may be positioned between the ball 413 and the ring 412.

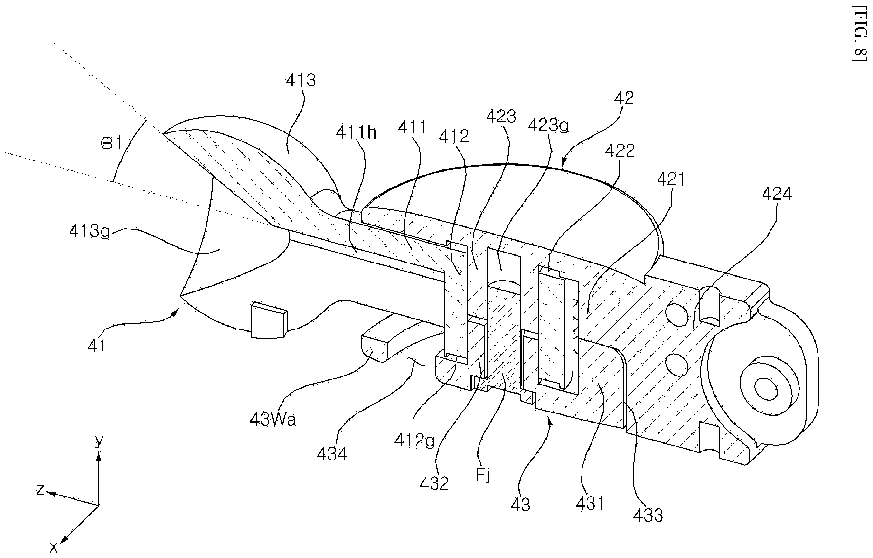

The ring 412 may be formed in a hollow cylindrical or cylindrical shape extending in a direction intersecting the body 411. For example, the ring 412 may extend vertically. The ring 412 may be coupled to an end of the body 411. A ring hole 412h may be formed through upper and lower surfaces of the ring 412. The upper protruding portion 421 and the lower protruding portion 431 may be inserted into the ring 412. An upper end of the ring 412 may be seated in the upper groove 422. Alternatively, a washer may be positioned in the upper groove 422, and the upper end of the ring 412 may be seated beneath the upper part 42 to be in contact with the washer. A lower end of the ring 412 may be seated on the lower part 43. A groove 423g (see FIG. 8) may be formed at the lower end of the ring 412, and a washer may be positioned in the groove 423g.

A fastening member Fj such as a screw may pass through the hole 431h of the lower protruding portion 431 and the ring hole 412h of the ring 412 and be fastened to the groove 421g of the upper protruding portion 421. Accordingly, the ball hinge 41 may rotate about the pin 423, 432.

The ball 413 may be coupled to an end of the body 411, and may be opposite the ring 412 with respect to the body 411. The ball 413 may be positioned outside the joint 42, 43. The ball 413 may be formed in a spherical shape, and a front end thereof may be cut and flattened. A groove 413g may be formed by being recessed rearward from the front end of the ball 413. A diameter of the groove 413g may gradually decrease from the front end of the ball 413 toward the rear. For example, the groove 413g may be formed in a conical shape. A cutting part 413c may be open to the bottom of the ball 413.

A hole 411h of the body 411 may extend along a longitudinal direction of the body 411, and may be open toward the groove 413g of the ball 413. The hole 411h may be formed at a central portion of the groove 413g, and may extend from the central portion of the groove 413g to the inside of the body 411. A cutting part 411c of the body 411 may be open to the bottom of the body 411. The cutting part 411c of the body 411 may be open from at least a portion of an inner surface of the hole 411h to the bottom of the body 411, and may be in communication with the hole 411h. The cutting part 411c of the body 411 may communicate with the cutting part 413c of the ball 413.

The groove 413g of the ball 413 may have a first angle θ1 with respect to the body 411. The diameter of the groove 413g may increase toward the front. The first angle θ1 may be an angle between an inner surface of the groove 413g and the inner surface of the hole 411h. The inner surface of the groove 413g may be referred to as a conical surface. The first angle θ1 may be an acute angle. For example, the first angle θ1 may be approximately 25 degrees.

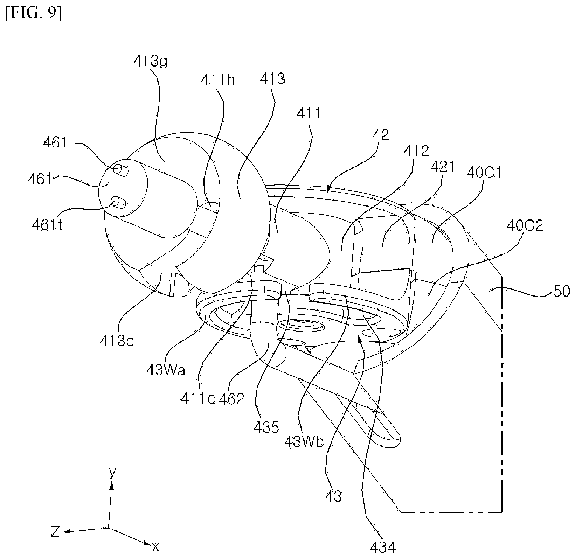

Referring to FIG. 9, the slot 434 may communicate with the cutting part 413c, 411c of the ball hinge 41 and the hole 411h of the body 411. The first slot wall 43Wa may be positioned under the body 411, and the second slot wall 43Wb may not overlap the body 411.

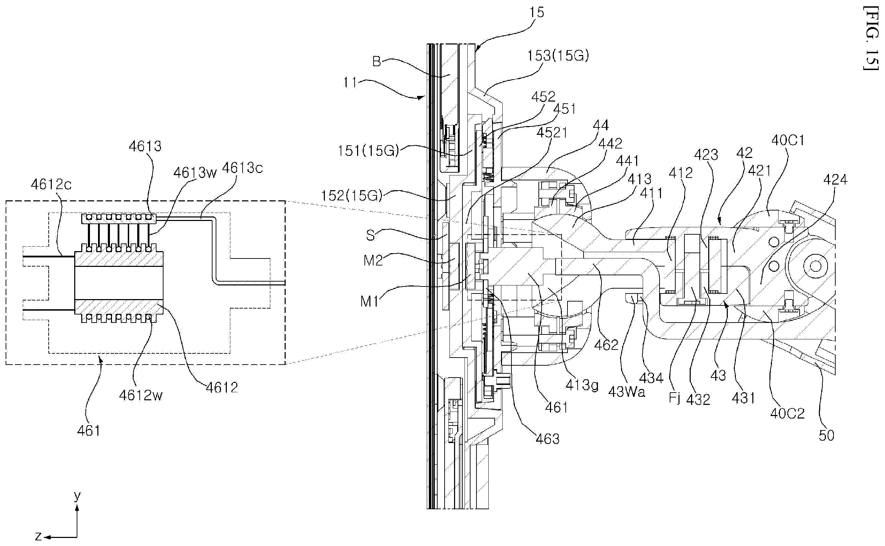

The connector 40 may include a rotary assembly 46. The rotary assembly 46 may include a rotary connector 461 and a cable 462. For example, the rotary connector 461 may be a slipring. For example, the rotary connector 461 may be a power transmission device. The rotary connector 461 may be surrounded by the ball 413 of the ball hinge 41. The rotary connector 461 may be positioned in the groove 413g of the ball 413 of the ball hinge 41, such that a portion thereof may protrude beyond the front of the ball 413. The rotary connector 461 may include a stator 4613 (see FIG. 15) and a rotator 4612 (see FIG. 15). The rotator 4612 (see FIG. 15) may rotate with respect to the stator 4613 (see FIG. 15). A connection portion 461t may be electrically connected to a first substrate 463 to be described later. The connection portion 461t may be positioned at the rotator 4612 (see FIG. 15) of the rotary connector 461. The rotator 4612 (see FIG. 15) of the rotary connector 461 may pivot and/or rotate together with the head 10. In this case, the stator 4613 (see FIG. 15) of the rotary connector 461 may not pivot and/or rotate together with the head 10.

The cable 462 may be electrically connected to an external power source. The cable 462 may be connected to the rotary connector 461 so as to transmit power to the rotary connector 461. The cable 462 may be connected to the stator of the rotary connector 461. The cable 462 may be received in the body 411 through the hole 411h of the body 411. The cable 462 may be received in the ball hinge 41 through the cutting part 413c, 411c of the ball hinge 41. The cable 462 may pass through the slot 434 through the cutting part 413c, 411c and extend into the support arm 50. In this case, the cable 462 may be fixed or secured by the first slot wall 43Wa. As the groove 413g is inclined at the first angle θ1 (see FIG. 8), the groove 413g may serve as an escape space (interference-avoiding space) for the cable 462 to move when the head 10 swivels, tilts, and/or rotates.

The rotary assembly 46 may include a first substrate 463. The first substrate 463 may be electrically connected to the rotary connector 461. The first substrate 463 may be positioned in a mount 45 to be described later, and may be fixed to the mount 45.

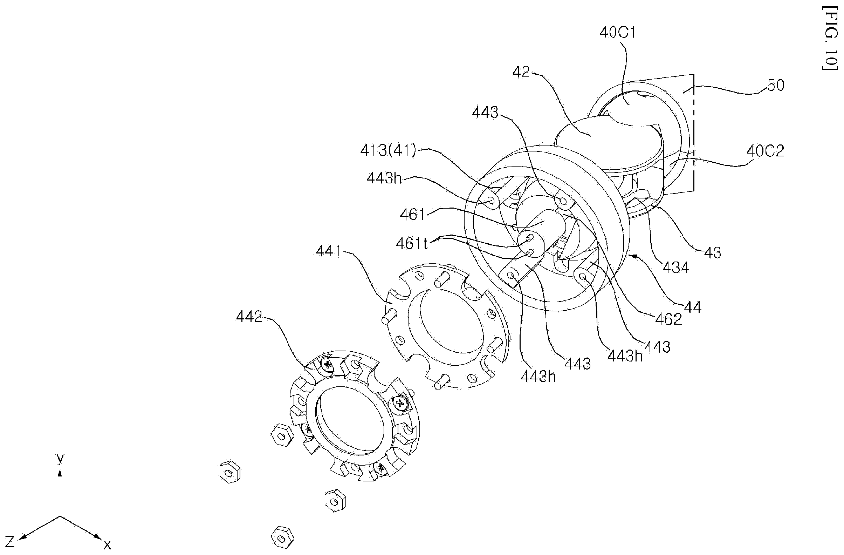

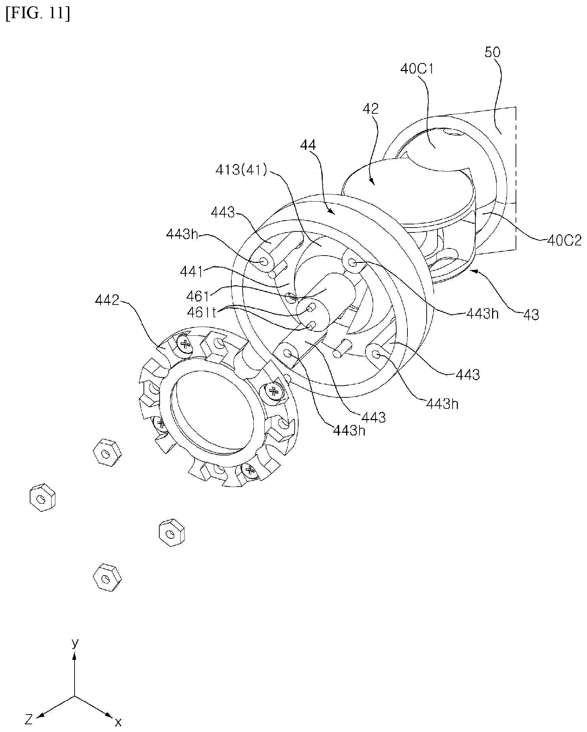

Referring to FIGS. 10 and 11, the cover 44 may cover the ball 413. The ball 413 may be positioned in the cover 44. A front surface of the cover 44 may be open, and a rear surface of the cover 44 may be provided with a hole. A rear end of the ball 413 or the body 411 may be positioned in the hole formed in the rear surface of the cover 44. A diameter of the hole formed in the rear surface of the cover 44 may be less than a diameter of the ball 415 and greater than a diameter of the body 411. Accordingly, the ball hinge 41 may be prevented from being separated from the cover 44.

A bracket 441, 442 may be positioned in the cover 44. The bracket 441, 442 may surround an outer circumference of the ball 413. The bracket 441 may be in contact with the surface of the ball 413. The bracket 441, 442 may include a first bracket 441 and a second bracket 442. The first bracket 441 and the rear surface of the cover 44 may be in contact with each other. The second bracket 442 may be positioned at the front of the first bracket 441. The second bracket 442 and the first bracket 441 may be coupled to each other via a fastening member such as a bolt, nut, or the like. The bracket 441, 442 may be in contact with an inner surface of the cover 44. The bracket 441, 442 may have a diameter corresponding to an inner diameter of the cover 44. The bracket 441, 442 may fix or secure the ball 413. Accordingly, the cover 44, the mount 45, and the head 10 may rotate with respect to the ball hinge 41.

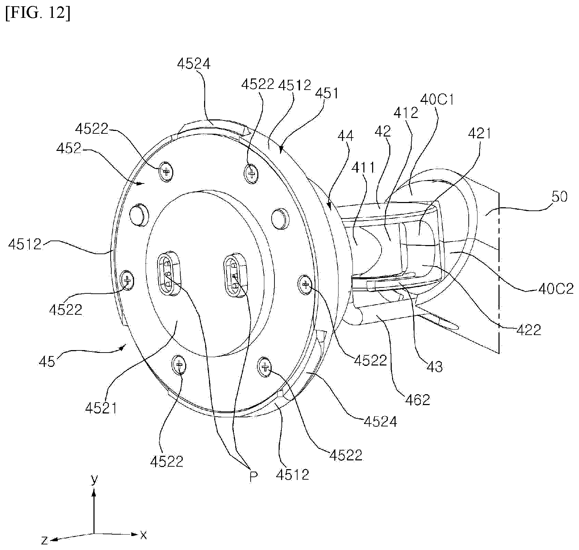

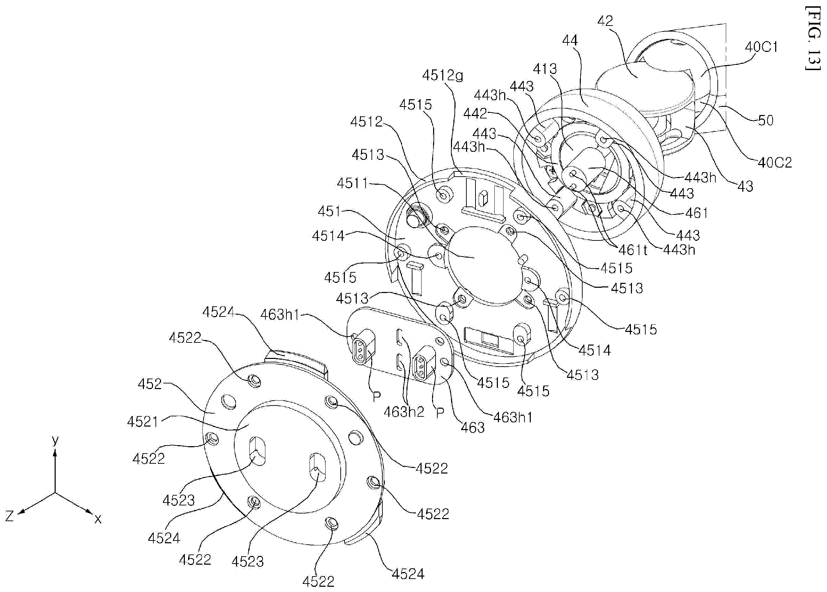

Referring to FIGS. 12 and 13, the cover 44 may include a pillar 443. The pillar 443 may be positioned in the cover 44. The pillar 443 may protrude inward from the inner surface of the cover 44. A plurality of pillars 443 may be provided. The plurality of pillars 443 may be spaced apart from each other along an inner circumferential surface of the cover 44. For example, the pillar 443 may include four pillars 443. A hole 443h may be formed in the pillar 443.

The cover 44 may be disposed at the rear of the mount 45, and may be coupled to the mount 45. The mount 45 may include a rear mount 451 and a front mount 452.

The rear mount 451 may have a disc shape. A hole 4511 may be formed through the rear mount 451 in the front-and-rear direction. The hole 4511 may be formed at a center of the rear mount 451. A slipring (SR) may be positioned in the hole 4511. A first fastening hole 4513 may be formed through the rear mount 451 in the front-and-rear direction. A plurality of first fastening holes 4513 may be provided. The plurality of first fastening holes 4513 may be spaced apart from each other along a circumference of the hole 4511. The first fastening hole 4513 may be aligned with the pillar 443 or the hole 443h of the pillar 443. A fastening member such as a screw may pass through the first fastening hole 4513 and be fastened to the hole 443h of the pillar 443. Accordingly, the cover 44 may be coupled to the rear mount 451.

A side part 4512 may protrude forward from an outer circumference of the rear mount 451. The side part 4512 may extend along a circumference of the rear mount 451. A side groove 4512g may be formed in the side part 4512, and may be formed by being recessed rearward from the side part 4512. A plurality of side grooves 4512g may be provided. The plurality of side grooves 4512g may be arranged to be spaced apart from each other in a circumferential direction of the rear mount 451. The rear mount 451 and the front mount 452 may be spaced apart by the side part 4512 when the rear mount 451 and the front mount 452 are coupled.

A second fastening hole 4514 may be formed through the rear mount 451 in the front-and-rear direction. A plurality of second fastening holes 4514 may be provided. The plurality of second fastening holes 4514 may be disposed between the plurality of first fastening holes 4513. For example, the plurality of second fastening holes 4514 may be provided as two second fastening holes 4514 and may be opposite each other with respect to the hole 4511.

A third fastening hole 4515 may be formed through the rear mount 451 in the front-and-rear direction. The third fastening hole 4515 may be positioned adjacent to the side part 4512. A plurality of third fastening holes 4515 may be provided. The plurality of third fastening holes 4515 may be spaced apart from each other along the circumference of the rear mount 451. The plurality of third fastening holes 4515 may be spaced apart from each other in the circumferential direction of the rear mount 451.

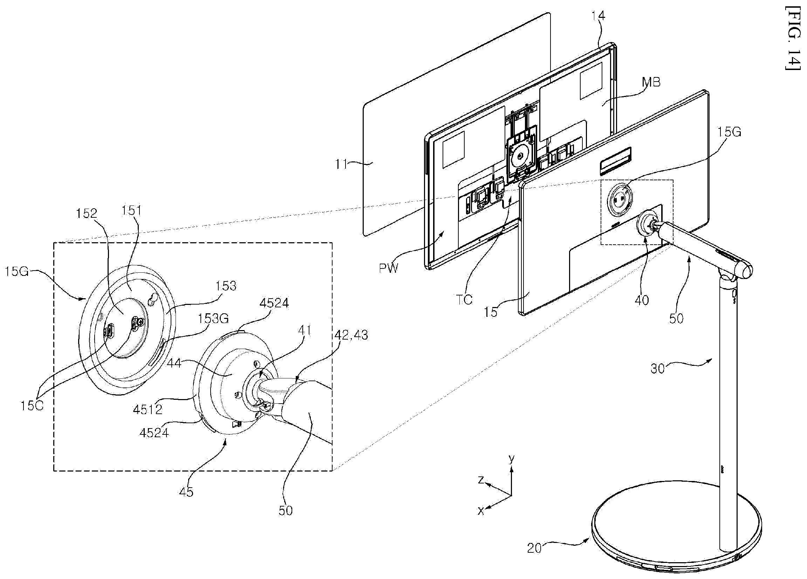

The front mount 452 may have the shape of a circular plate. The front mount 452 may be positioned at the front of the rear mount 451. The front mount 452 may be coupled to the rear mount 451. A protruding part 4521 may protrude forward from the front mount 452. The protruding part 4521 may be positioned at a central portion of the front mount 452. The protruding part 4521 may be aligned with a second groove 152 (see FIG. 14) of the back cover 15, which will be described later, and may be inserted into the second groove 152 (see FIG. 14) of the back cover 15.

A fastening hole 4522 may be formed through the front mount 452 in the front-and-rear direction. The fastening hole 4522 may be positioned outside the protruding part 4521. The fastening hole 4522 may be positioned adjacent to an outer circumference of the front mount 452. A plurality of fastening holes 4522 may be provided. The plurality of fastening holes 4522 may be spaced apart from each other along a circumference of the front mount 452. The fastening hole 4522 may be aligned with the third fastening hole 4515 of the rear mount 451. A fastening member such as a screw may pass through the fastening hole 4522 of the front mount 452 and be fastened to the third fastening hole 4515 of the rear mount 451. Accordingly, the rear mount 451 and the front mount 452 may be coupled to each other.

A coupling protrusion 4524 may protrude from the outer circumference of the front mount 452 in a radial direction of the front mount 452. The coupling protrusion 4521 may be aligned with the side groove 4512g of the rear mount 451, and may be seated in the side groove 4512g. A plurality of coupling protrusions 4521 may be provided. The plurality of coupling protrusions 4521 may be spaced apart from each other along the circumference of the front mount 452.

The rotary assembly 46 may include a first substrate 463. The first substrate 463 may be disposed between the rear mount 451 and the front mount 452. The first substrate 463 may be coupled to the rear mount 451. A fastening hole 463h1 of the first substrate 463 may be aligned with the second fastening hole 4514 of the rear mount 451. A fastening member such as a screw may pass through the fastening hole 463h1 of the first substrate 463 and be fastened to the second fastening hole 4514 of the rear mount 452. Accordingly, the first substrate 463 may be fixed to the rear mount 451. The first substrate 463 may be positioned in the hole 4511 of the rear mount 451. The first substrate 463 may be exposed at the rear of the mount 45 through the hole 4511 of the rear mount 451. Accordingly, the connection portion 461t of the rotary connector 461 may be inserted into a terminal hole 463h2 of the first substrate 463, and the rotary connector 461 and the first substrate 463 may be electrically connected to each other.

The rotary assembly 46 may include a coupling pin P. The coupling pin P may be mounted on the first substrate 463. The coupling pin P may be mounted on a front surface of the first substrate 463. The coupling pin P may be electrically connected to the first substrate 463. A plurality of coupling pins 463 may be provided. The plurality of coupling pins P may be spaced apart from each other.

A pin hole 4523 may be formed through the front mount 452 in the front-and-rear direction. The pin hole 4523 may be formed through the protruding part 3421 in the front-and-rear direction. A plurality of pin holes 4523 may be provided. The plurality of pin holes 4523 may be spaced apart from each other. The pin hole 4523 may be aligned with coupling pin P. The coupling pin P may pass through the pin hole 4523, and may protrude toward the front of the front mount 452.

Referring to FIG. 14, a plurality of electronic components PW, MB, TC may be positioned between the display panel 11 and the back cover 15. For example, the plurality of electronic components PW, MB, TC may be mounted on a front surface of the back cover 15. As another example, the plurality of electronic components PW, MB, TC may be mounted on a front surface or a rear surface of the frame 13 (see FIG. 3) disposed at the front of the back cover 15. Examples of the plurality of electronic components PW, MB, and TC are described as follows.

A power supply board PW may provide power to each component of the display device. For example, the power supply board PW may provide power to the display panel 11, a main board MB, a timing controller board TC, and a battery B (see FIG. 15). The main board MB may control the display device. The timing controller board TC may be electrically connected to the display panel 11 via a cable (not shown), and may provide an image (or video) signal to the display panel 11.

A mount groove 15G may be formed at a center of the back cover 15, and may be aligned with the connector 40. The mount 45 may be inserted into the mount groove 15G.

The mount groove 15G may include a first groove 151. The first groove 151 may be formed by being recessed forward from a rear surface of the back cover 15. The first groove 151 may be formed in a circular shape, and may have a size corresponding to the mount 45. The mount 45 may be inserted into the first groove 151, and the front mount 452 may be seated in the first groove 151.

The mount groove 15G may include a second groove 152. The second groove 152 may be formed in the first groove 151. The second groove 152 may be formed by being recessing forward from the first groove 151. The second groove 152 may be positioned at a center of the first groove 151. The protruding part 4521 of the front mount 452 may be inserted into the second groove 152 (see FIG. 13).

The mount groove 15G may include a protruding portion 153. The protruding portion 153 may protrude from the rear surface of the back cover 15, and may be positioned in a portion of the back cover 15 that defines a boundary of the first groove 151. The protruding portion 153 may cover a circumference of the mount 45. The protruding portion 153 may face the side part 1512. A coupling groove 153G may be formed on an inner circumferential surface of the protruding portion 153. The coupling groove 153G may be aligned with the coupling protrusion 4521 (see FIG. 13). The coupling protrusion 4521 (see FIG. 13) may be fitted into the coupling groove 153G. Accordingly, the mount 45 may be coupled and fixed to the mount groove 15G.

Referring to FIG. 15, the rotary connector 461 may be a slipring. The rotary connector 461 may include a housing 4611. The housing 4611 may define an outer appearance of the rotary connector 461. The housing 4611 may accommodate the stator 4613 and the rotor 462 therein. The connection portion 461t may be coupled to one surface of the housing 4611, and may protrude from the one surface of the housing 4611. The housing 4611 may be formed of an insulating material, and the connection portion 461t may be formed of a conductive material.

The rotator 4612 may be disposed within the housing 4611, and may be rotatably coupled to the housing 4611. The rotator 4612 may be formed of an insulating material, and a helical groove may be formed on an outer surface of the rotator 4612. A wire 4612w may be wound around the helical groove formed on the outer surface of the rotator 4612. Alternatively, a plurality of grooves may be formed on the outer surface of the rotator 4612 along an outer circumferential surface of the rotator 461, and the wire 4612w in the form of a ring may be positioned in each of the plurality of grooves.

For example, the rotator 4612 may be formed in a cylindrical or hollow cylindrical shape. A connection terminal may be embedded in the rotator 4612. A lead wire 4612c may be in contact with and/or electrically connected to the connection terminal of the rotator 4612, and may be exposed outside the rotator 4612. The lead wire 4612c may be connected to the connection portion 461t of the rotary connector 461. The lead wire 4612c may be in contact with or electrically connected to the connection portion 461t of the rotary connector 461.

The stator 4613 may be disposed within the housing 4611, and may be fixed to an inner wall of the housing 4611. The stator 4613 may be spaced apart from the rotator 4612 in a radial direction of the rotator 4612. The stator 4613 may be formed of an insulating material. A connection terminal may be embedded in the stator 4613, and a connection line 4613c may be in contact with or electrically connected to the connection terminal. The connection line 4613c may extend from the connection terminal of the stator 4613 and be exposed outside the stator 4613, and may be connected to the cable 462. A plurality of brush wires 4613w may be fixed to the stator 4613. One end of the brush wire 4613w may be fixed to the stator 4613, and the other end thereof may be in contact with the wire 4612w of the rotator 4612.

Accordingly, even when the rotator 4612 rotates together with the head 10, a connected state between the brush wire 4613w and the wire 4612w of the rotator 4612 may be maintained, allowing the electrical contact/connected state to be maintained. In addition, even when the rotator 4612 rotates together with the head 10, the stator 4613 coupled to the cable 462 does not rotate, thereby preventing the cable 462 from tangling. This enables the head 10 to rotate 360 degrees or pivot without limitation (i.e., infinite pivoting).

The stator 4613 may be fixed to an inner wall of the housing 4611. The rotator 462 may be rotatably coupled within the housing 4611.

The rotary connector 461 may include the stator 4613 (see FIG. 15) and the rotator 4612 (see FIG. 15).

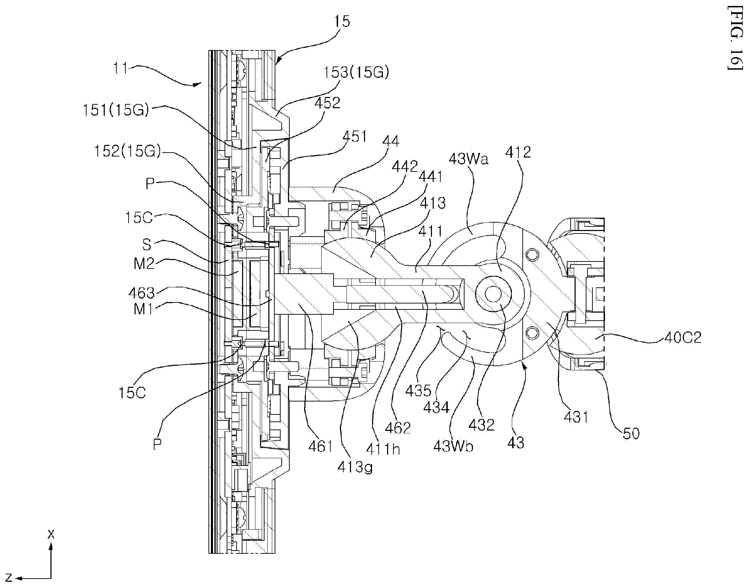

Referring to FIGS. 15 and 16, the power supply board PW may include a second substrate S. The second substrate S may be coupled to the back cover 15. The second substrate S may be coupled to the second groove 152 of the mount groove 15G. A fastening member such as a screw may pass through the second groove 152 of the mount groove 15G and be fastened to the second substrate S.

A pinhole 15H may be formed through the back cover 15 in the front-and-rear direction. The pin hole 15H may be formed in the second groove 152. The pin hole 15H may be aligned with the coupling pin P, and the coupling pin P may be inserted thereinto. A pin coupling portion 15C may be electrically connected to the second substrate S2. The pin coupling portion 15C may be mounted on the second substrate S, and may protrude rearward from the second substrate S. The pin coupling portion 15C may pass through the pin hole 15H. The pin coupling portion 15C may be positioned in the pin hole 15H. The pin coupling portion 15C may be shaped to engage with the coupling pin P. The coupling pin P may be inserted into the pin hole 15H and coupled to the pin coupling portion 15C. Accordingly, the first substrate 463 and the second substrate S may be electrically connected to each other, and power may be transmitted to the power supply board PW via the second substrate S.

A first magnet M1 may be positioned in the front mount 452. The first magnet M1 may be embedded in the protruding part 4521 of the front mount 452. The first magnet M1 may be disposed between the plurality of pin holes 4523. A second magnet M2 may be positioned in the back cover 15. The second magnet M2 may be embedded in the second groove 152 of the back cover 15, and may face the first magnet M1. The first magnet M1 and the second magnet M2 may have opposite polarities. For example, the first magnet M1 may be the N pole, and the second magnet M2 may be the S pole. An attractive force may act between the first magnet M1 and the second magnet M2, thereby enhancing the coupling force between the mount 45 and the back cover 15.

The battery B may be mounted to the head 10. The battery B may be electrically connected to the power supply board PW (see FIG. 14), and may receive power from the power supply board PW (see FIG. 14). The battery B may be provided as a rechargeable battery B. When the pin P and the pin coupling portion 15C are connected as the stand (20, 30, 50, 40) (see FIG. 2) is mounted on the head 10, the power supply board PW (see FIG. 14) may be supplied with power via the cable 462 (see FIG. 9) and supply the power to the battery B, allowing the battery B to be charged. When the stand (20, 30, 50, 40) (see FIG. 2) is detached from the head 10, the power supply board PW (FIG. 14) may provide power to each component of the head 10 using the power of the battery B. In other words, the head 10 can be used alone separated from the stand (20, 30, 50, 40) (see FIG. 2). For example, the battery B may be a rechargeable battery.

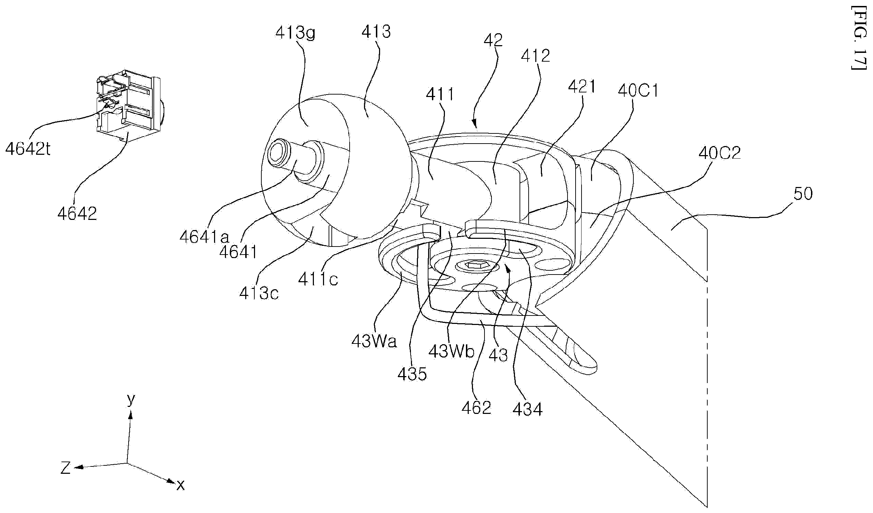

Referring to FIG. 17, the connector 40 may include a rotary assembly 46. The rotary assembly 46 may include a rotary connector 464 and a cable 462. The rotary connector 464 may be a power transmission device. The rotary connector 464 may be surrounded by the ball 413 of the ball hinge 41. The rotary connector 464 may be positioned in the groove 413g of the ball 413 of the ball hinge 41, such that a portion thereof may protrude beyond the front of the ball 413. The rotary connector 464 may include a stator 4641 and a rotator 4642. The rotator 4642 may rotate with respect to the stator 4641. The rotator 4642 may be electrically connected to a first substrate 463 to be described later. A connection portion 4642t may be formed at the rotator 4642, and may be mounted on the first substrate 463. The rotator 4642 may pivot and/or rotate with head 10. In this case, the stator 4641 may not pivot and/or rotate together with the head 10. The stator 4641 may be referred to as a plug, and the rotator 4642 may be referred to as a jack.

The cable 462 may be electrically connected to an external power source. The cable 462 may be connected to the rotary connector 464 so as to transmit power to the rotary connector 464. The cable 462 may be connected to the stator 4641 of the rotary connector 464. The cable 462 may be received in the body 411 through the hole 411h of the body 411. The cable 462 may be received in the ball hinge 41 through the cutting part 413c, 411c of the ball hinge 41. The cable 462 may pass through the slot 434 through the cutting part 413c, 411c and extend into the support arm 50. In this case, the cable 462 may be fixed or secured by the first slot wall 43Wa. As the groove 413g is inclined at the first angle θ1 (see FIG. 8), the groove 413g may serve as an escape space (interference-avoiding space) for the cable 462 to move when the head 10 swivels, tilts, and/or rotates.

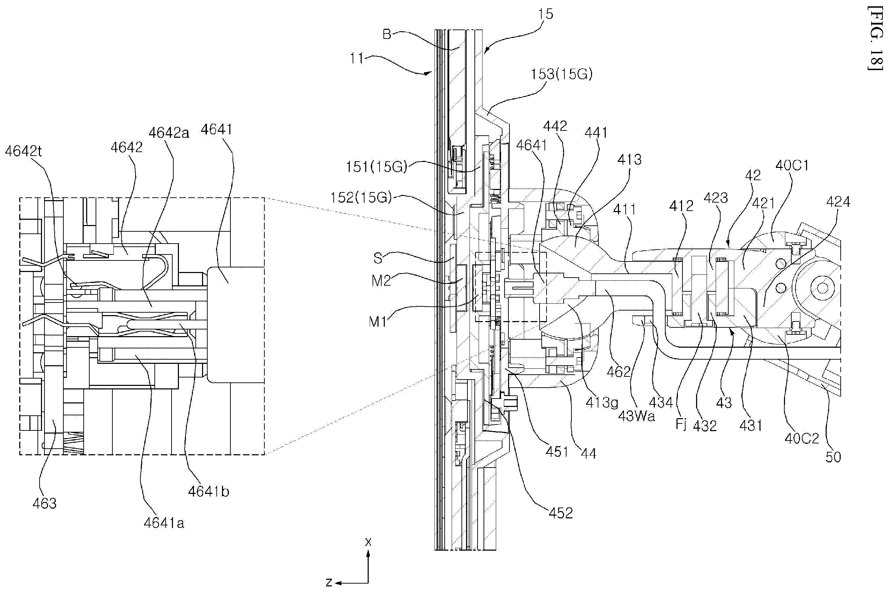

Referring to FIG. 18, the stator 4641 of the rotary connector 464 may include a stationary body 4641a, and a protruding body 4641b, 4641c protruding forward from the stationary body 4641a. The stationary body 4641a may be formed of an insulating material. The stationary body 4641a may be coupled to the cable 462, and a portion of the cable 462 may be inserted into the stationary body 4641a. The protruding body 4641b, 4641c may be formed of a conductive material. For example, the protruding body 4641b, 4641c may include a metal material. A portion of the protruding body 4641b, 4641c may be inserted into the stationary body 4641a, and may be connected to the cable 462. The protruding body 4641b, 4641c may include a first part 4641b of a hollow cylindrical shape, and a second part 4641c of a rod shape that is accommodated in the first part 4641b.

The rotator 4642 of the rotary connector 464 may include a first part 4642a and a second part 4642b. The first part 4641a may be formed of an insulating material, and the second part 4642b may be formed of a conductive material. For example, the second part 4642b may be made of a metal material. An internal space may be formed in the first part 4641a, and the connection portion 4642t may be fixed to the internal space. A portion of the second part 4642b may be accommodated in the internal space of the first part 4642a, and a remaining portion thereof may protrude from the first part 4642a. The second part 4642b may contact the second substrate S. The second part 4642b may fix or secure the connection portion 4642t. A groove or a hole in which the connection portion 4642t is accommodated may be formed in the second part 4642b.

The connection portion 4642t may be formed of a conductive material. The connection portion 4642t may be made of a metal material. The connection portion 4642t may be bent or bent a plurality of times. A first connection portion 4642t1 may be fixed to the first part 4641a, and a second connection portion 4642t2 may be fixed to the second part 4641b. Each end of the first and second connection portions 4642t1 and 4642t2 may contact the second substrate S. The first and second connection portions 4642t1 and 4642t2 may contact each other.

When the stator 4641 is coupled to the rotator 4642, the first part 4641b of the protruding body 4641b, 4641c may be inserted into the second part 4642a of the rotator 4641, and the second part 4641c of the protruding body 4641b, 4641c may be inserted into the groove of the second part 4642b of the rotator 4642. The first connection portion 4642t1 may contact the first part 4641b of the protruding body 4641b, 4641c, and the second connection portion 4642t2 may contact the second part 4642b of the rotator 4642.

When the rotator 4642 rotates together with the head 10, the second part 4642b may be rotated along an inner surface of the second part 4642b of the protruding body 4641b, 4641c. In this case, the contact between the first part 4641b of the protruding body 4641b, 4641c and the first connection portion 4642t1 may be maintained, and the contact between the second part 4641c of the protruding body 4641b, 4641c and the second connection portion 4642t2 may be maintained.

Accordingly, even when the rotator 4642 rotates together with the head 10, the stator 4641 coupled to the cable 462 does not rotate, thereby preventing the cable 462 from tangling. This enables the head 10 to rotate 360 degrees or pivot without limitation (i.e., infinite pivoting). In addition, even when the head 10 is pivoted infinitely, an electrical contact between the stator 4641 and the rotator 4642 may be maintained, thereby preventing electrical contact failure.

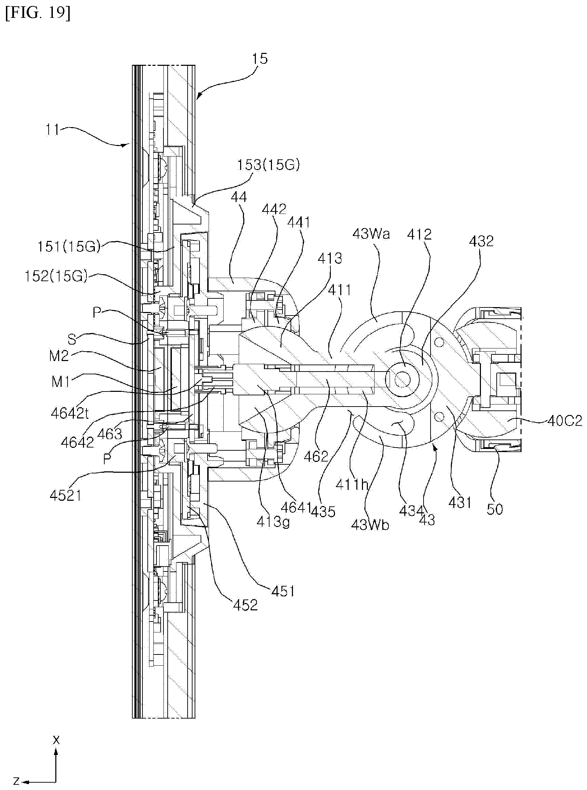

Referring to FIGS. 18 and 19, the rotary assembly 46 may include a first substrate 463. The first substrate 463 may be electrically connected to the rotary connector 461. The first substrate 463 may be positioned in the mount 45, and may be fixed to the mount 45. The first substrate 463 may be disposed between the rear mount 451 and the front mount 452. The first substrate 463 may be fixed to the front mount 452. The rotator 4642 of the rotary connector 461 may pass through the hole 4511 of the rear mount 451, and the connection portion 4642t may be mounted on the first substrate 463.

A coupling pin P may be mounted on the first substrate 463. The coupling pin P may be mounted on a front surface of the first substrate 463. The coupling pin P may be electrically connected to the first substrate 463. A plurality of coupling pins 463 may be provided. The plurality of coupling pins P may be spaced apart from each other. A pin hole 4523 may be formed through the front mount 452 in the front-and-rear direction. The pin hole 4523 may be formed through the protruding part 3421 in the front-and-rear direction. A plurality of pin holes 4523 may be provided. The plurality of pin holes 4523 may be spaced apart from each other. The pin hole 4523 may be aligned with the coupling pin P. The coupling pin P may pass through the pin hole 4523, and may protrude toward the front of the front mount 452.

A pin hole 15H of the back cover 15 may be formed through the back cover 15 in the front-and-rear direction. The pin hole 15H may be formed in the second groove 152. The pin hole 15H may be aligned with the coupling pin P, and the coupling pin P may be inserted thereinto. A pin coupling portion 15C may be electrically connected to the second substrate S2. The pin coupling portion 15C may be mounted on the second substrate S, and may protrude rearward from the second substrate S. The pin coupling portion 15C may pass through the pin hole 15H. The pin coupling portion 15C may be positioned in the pin hole 15H. The pin coupling portion 15C may be shaped to engage with the coupling pin P. The coupling pin P may be inserted into the pin hole 15H, and may be coupled to the pin coupling portion 15C. Accordingly, the first substrate 463 and the second substrate S may be electrically connected to each other, and power may be transmitted to the power supply board PW via the second substrate S.

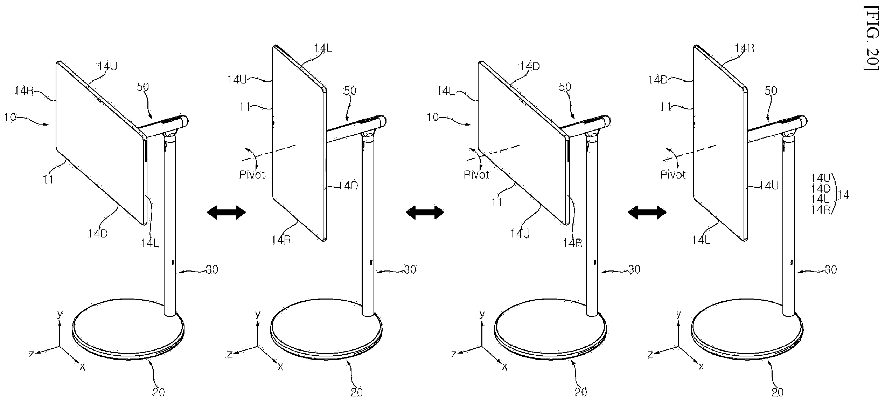

Referring to FIG. 20, the head 10 may be spaced upward from the base 20. A user can pivot the head 10. A user can rotate the head 10. The pivot axis/rotation axis may pass through a center of the head 10 and be perpendicular to the head 10, and may be defined by the ball hinge 41. The head 10 may be pivoted/rotated with respect to ball hinge 41.

The head 10 may be pivoted in both directions with respect to the pivot axis. The head 10 may be rotated 360 degrees about the pivot axis. The head 10 may be pivoted to be placed in a landscape mode or a portrait mode. When the head 10 pivots/rotates, the mount 45, the cover 44, and the rotator of the rotary connector 461 may be pivoted/rotated together with the head 10, and the stator of the rotary connector 461 and the ball hinge 41 may be stationary. Accordingly, it is possible to prevent the cable 462 connected to the stator of the rotary connector 461 from tangling, and to maintain an electrical contact during the pivoting of the head 10.

Referring to FIGS. 1 to 20, a display device according to an aspect of the present disclosure may include: a head including a display panel; a stand to support the head; and a connector to connect the head and the stand, the connector including a rotary assembly configured to rotatably connect the head to the stand. The rotary assembly may include: a rotary connector including a rotator coupled to the head so as to rotate together with the head, and a stator rotatably coupled to the rotator so as to rotate relative to the head; and a cable which is passing through the stator and which is electrically connected to the display panel.

The connector may include: a ball hinge; and a bracket to which the ball hinge is rotatably coupled and fixed to the head. The ball hinge may include: a ball surrounded by the bracket of the head and configured to move in contact with the bracket; a body extending from an outer surface of the ball; a ring which is opposite the ball with respect to the body and which is formed at an end of the body; and a hole formed through the ball and the body and into which the cable is inserted. At least a portion of the hole may gradually increase in diameter in a direction from the body toward the head.

The ball may include a cutting part that is cut from the hole to the outer surface of the ball in a radial direction of the ball.

The cutting part may be further cut from a hole formed inside the body toward an outer surface of the body.

The connector may include a joint coupled to the stand, the joint including a pin that protrudes in a direction intersecting a direction from the head toward the joint. The ring of the ball hinge may include a pin hole into which the pin is inserted, the pin hole being formed in a direction parallel to the direction in which the pin protrudes.

The joint may include: an upper part positioned over the ring of the ball hinge; and a lower part which is positioned under the ring of the ball hinge and which is coupled to the upper part. The lower part may include a slot formed through an upper surface and a lower surface of the lower part and extending along a circumference of the lower part, the slot having at least a portion overlapping a cutting part of the ball hinge. The cable may be bent in the hole of the ball hinge to be placed in the slot.

The lower pat may include: a first slot wall that defines a front boundary of the slot; a second slot wall which defines a front boundary of the slot and which is spaced apart from the first slot wall in a circumferential direction of the lower part; and an opening formed between the first slot wall and the second slot wall and disposed so as not to vertically overlap the hole of the ball hinge. The cable may be engaged with any one of the first slot wall or the second slot wall.

The connector may include: a mount coupled to the head and the rotator of the rotary assembly; and a cover coupled to the mount and in which the ball of the ball hinge and the bracket are accommodated.

The mount may include: a rear mount having a hole through which the rotator passes, the hole being formed at a center of the rear mount; and a front mount which is positioned at a front of the rear mount and which is coupled to the rear mount. The rotary assembly may include a first substrate that is disposed between the rear mount and the front mount and fixed to the rear mount, the first substrate being exposed at a rear through the hole of the rear mount. The rotator may be electrically connected to the first substrate.

The head may include: a back cover to cover one surface of the display panel; a mount groove recessed forward from a rear surface of the back cover; a protruding portion protruding rearward from the rear surface of back cover, the protruding portion defining a boundary of the mount groove; and a coupling groove formed on an inner surface of the protruding portion. The mount may include a coupling protrusion protruding from an outer circumferential surface of the front mount in a radial direction of the front mount, the coupling protrusion being inserted into the coupling groove of the back cover.

The rotary assembly may include a coupling pin mounted on the first substrate, the coupling pin passing through the front mount so as to protrude forward from the mount. The head may include a pin hole formed through the back cover, positioned in the mount groove, and into which the coupling pin is inserted.

The head may include a power supply board. The power supply board may include: a second substrate which is disposed between the display panel and the mount groove of the back cover and which is fixed to the back cover; and a pin coupling portion mounted on the second substrate, positioned in the pin hole of the back cover, and electrically connected to the coupling pin.

The head may include a battery positioned between the display panel and the back cover, the battery being electrically connected to the power supply board.

The display device may further include a first magnet which is embedded in the mount and which is having a first polarity; and a second magnet which is embedded in the mount groove of the back cover and which is disposed opposite the first magnet with respect to the back cover, the second magnet having a second polarity opposite to the first polarity.

The head may be rotatable 360 degrees with respect to the ball hinge.

Certain embodiments or other embodiments of the disclosure described above are not mutually exclusive or distinct from each other. Any or all elements of the embodiments of the disclosure described above may be combined or combined with each other in configuration or function.

For example, a configuration "A" described in one embodiment of the disclosure and the drawings, and a configuration "B" described in another embodiment of the disclosure and the drawings may be combined with each other. Namely, although the combination between the configurations is not directly described, the combination is possible except in the case where it is described that the combination is impossible.

The above detailed description is to be construed in all aspects as illustrative and not restrictive. The scope of the present disclosure should be determined by reasonable interpretation of the appended claims, and all changes coming within the equivalency range of the present disclosure are intended to be embraced in the scope of the present disclosure.

## Claims

1. A display device comprising:
a head including a display panel;
a stand supporting the head; and
a connector connecting the head and the stand, the connector including a rotary assembly rotatably connecting the head to the stand,
wherein the rotary assembly comprises:
a rotary connector including a rotator coupled to the head so as to rotate together with the head, and a stator rotatably coupled to the rotator so as to rotate relative to the head; and
a cable which is passing through the stator and which is electrically connected to the display panel.

2. The display device of claim 1, wherein the connector comprises:
a ball hinge; and
a bracket to which the ball hinge is rotatably coupled, the bracket being fixed to the head,
wherein the ball hinge comprises:
a ball surrounded by the bracket of the head and configured to move in contact with the bracket;
a body extending from an outer surface of the ball;
a ring which is opposite the ball with respect to the body and which is formed at an end of the body; and
a hole formed through the ball and the body and into which the cable is inserted, and
wherein at least a portion of the hole gradually increases in diameter in a direction from the body toward the head.

3. The display device of claim 2, wherein the ball includes a cutting part that is cut from the hole to the outer surface of the ball in a radial direction of the ball.

4. The display device of claim 3, wherein the cutting part is further cut from a hole formed inside the body toward an outer surface of the body.

5. The display device of claim 2, wherein the connector comprises a joint coupled to the stand, the joint including a pin that protrudes in a direction intersecting a direction from the head toward the joint, and wherein the ring of the ball hinge includes a pin hole into which the pin is inserted, the pin hole being formed in a direction parallel to the direction in which the pin protrudes.

6. The display device of claim 5, wherein the joint comprises:
an upper part positioned over the ring of the ball hinge; and
a lower part which is positioned under the ring of the ball hinge and which is coupled to the upper part, wherein the lower part includes a slot formed through an upper surface and a lower surface of the lower part and extending along a circumference of the lower part, the slot having at least a portion overlapping a cutting part of the ball hinge, and
wherein the cable is bent in the hole of the ball hinge to be placed in the slot.

7. The display device of claim 6, wherein the lower part comprises:
a first slot wall that defines a front boundary of the slot;
a second slot wall which defines a front boundary of the slot and which is spaced apart from the first slot wall in a circumferential direction of the lower part; and
an opening formed between the first slot wall and the second slot wall, the opening being disposed so as not to vertically overlap the hole of the ball hinge, and
wherein the cable is engaged with any one of the first slot wall or the second slot wall.

8. The display device of claim 2, wherein the connector comprises:
a mount coupled to the head and the rotator of the rotary assembly; and
a cover coupled to the mount and in which the ball of the ball hinge and the bracket are accommodated.

9. The display device of claim 8, wherein the mount comprises:
a rear mount having a hole through which the rotator passes, the hole being formed at a center of the rear mount; and
a front mount which is positioned at a front of the rear mount and which is coupled to the rear mount, wherein the rotary assembly comprises a first substrate that is disposed between the rear mount and the front mount and fixed to the rear mount, the first substrate being exposed at a rear through the hole of the rear mount, and
wherein the rotator is electrically connected to the first substrate.

10. The display device of claim 9, wherein the head comprises:
a back cover to cover one surface of the display panel;
a mount groove recessed forward from a rear surface of the back cover;
a protruding portion protruding rearward from the rear surface of the back cover, the protruding portion defining a boundary of the mount groove; and
a coupling groove formed on an inner surface of the protruding portion, and
wherein the mount comprises a coupling protrusion protruding from an outer circumferential surface of the front mount in a radial direction of the front mount, the coupling protrusion being inserted into the coupling groove of the back cover.

11. The display device of claim 10, wherein the rotary assembly includes a coupling pin mounted on the first substrate, the coupling pin passing through the front mount so as to protrude forward from the mount, and wherein the head includes a pin hole formed through the back cover, positioned in the mount groove, and into which the coupling pin is inserted.

12. The display device of claim 11, wherein the head includes a power supply board, and
wherein the power supply board comprises:
a second substrate which is disposed between the display panel and the mount groove of the back cover and which is fixed to the back cover; and
a pin coupling portion mounted on the second substrate, positioned in the pin hole of the back cover, and electrically connected to the coupling pin.

13. The display device of claim 10, wherein the head includes a battery positioned between the display panel and the back cover, the battery being electrically connected to the power supply board.

14. The display device of claim 10, further comprising:
a first magnet which is embedded in the mount and which is having a first polarity; and
a second magnet which is embedded in the mount groove of the back cover and which is disposed opposite the first magnet with respect to the back cover, the second magnet having a second polarity opposite to the first polarity.

15. The display device of claim 2, wherein the head is rotatable 360 degrees with respect to the ball hinge.
